# EUROPEAN PATENT APPLICATION

(11) **EP 4 235 304 A1**
(43) Date of publication of application: **30.08.2023**
(21) Application number: 21897421.0
(22) Date of filing: 23.08.2021
(51) Int. Cl.: G03F 7/20, H05G 2/00

(54) **ROTARY FOIL TRAP AND LIGHT SOURCE DEVICE**

(30) Priority: 25.11.2020 JP 2020195077
(71) Applicant: Ushio Denki Kabushiki Kaisha, Tokyo 100-8150 (JP)
(72) Inventor: YABUTA Hironobu, Tokyo 100-8150 (JP)
(74) Representative: Tomerius, Isabel
(86) International application number: PCT/JP2021/030807
(87) International publication number: WO 2022/113443

(57) **Abstract**

Disclosed herein is a rotary foil trap capable of having a relatively long-term operating life without causing any short-term defects such as foil rupture, and also a light source apparatus equipped with the rotary foil trap. The rotary foil trap (22) is arranged in a vicinity of plasma P generated by a plasma generation unit and configured to rotationally operate to transmit light emitted from the plasma P and to trap debris dispersed from the plasma P. The rotary foil trap (22) includes a plurality of foils (51) and a support member (hub) (53) configured to support the plurality of foils. Each of the foils (51) is made of a rolled thin plate that is tensile processed by rolling, and a direction of centrifugal force applied to the foils (51) by rotational operation coinciding or approximately coinciding with a rolling direction, which is a direction in which the foils (51) are tensile processed.

## Description

### TECHNICAL FIELD

The present invention relates to a rotary foil trap that traps debris dispersed from high-temperature plasma and to a light source apparatus equipped with the rotary foil trap.

### BACKGROUND ART

In recent years, as semiconductor integrated circuits have become finer and more integrated, light sources for exposure have become increasingly shorter wavelengths. As light sources for next-generation semiconductor exposure, extreme ultraviolet light source apparatuses (hereinafter referred to as "EUV (Extreme Ultra Violet) light source apparatuses") that emit extreme ultraviolet light with 13.5 nm wavelength (hereinafter referred to as "EUV light") has been under development.

For such EUV light source apparatuses, several methods have been known for generating EUV light (i.e., EUV radiation). One of those methods is to heat and excite extreme ultraviolet light radiation species (hereinafter also referred to as "EUV radiation species") to generate high-temperature plasma so as to extract EUV light from the generated high-temperature plasma.

EUV light source apparatuses employing such a method may be classified into two types according to the generation method of the high-temperature plasma: the Laser Produced Plasma (LPP) type method and the Discharge Produced Plasma (DPP) type method.

The DPP type EUV light source apparatus applies high voltage to the gap between electrodes supplied with discharge gas containing the EUV radiation species (e.g., plasma raw material in a gas phase), generates high-density high-temperature plasma by discharge, and uses the extreme ultraviolet light emitted therefrom. For the DPP type method, as disclosed in, for example, the Patent Literature 1 (Laid-open Publication of Japanese Patent Application No. 2017-219698 A), a certain method has been proposed in which a high-temperature plasma raw material in a liquid phase (e.g., tin (Sn)) is supplied to the electrode surface that generates the discharge, the high-temperature plasma raw material is vaporized by irradiating the high-temperature plasma raw material with an energy beam such as a laser beam, and then the high-temperature plasma is generated by the discharge. In some cases, such a method may also be referred to as the Laser assisted Discharge Plasma (LDP) type method.

EUV light source apparatuses may be used as light source apparatuses for lithography equipment in manufacturing semiconductor devices. Alternatively, EUV light source apparatuses may be used as light source apparatuses for mask inspection equipment used in the lithography. In other words, EUV light source apparatuses are used as light source apparatuses for other optical system apparatuses that apply the EUV light (i.e., application apparatuses).

Since the EUV light tends to attenuate in air, the EUV light is kept in a reduced pressure atmosphere, in other words, vacuum, from the plasma to the application apparatus.

On the other hand, debris is dissipated at high speed from the plasma generated by the LDP type method. Debris contains particles of high-temperature plasma raw material (tin particles in case that the plasma raw material is tin) and particles of materials of the discharge electrodes that are sputtered during the plasma being generated. When debris reaches the application apparatus, the debris may damage or contaminate the reflective film of the optical elements in the application apparatus, thereby deteriorating performance thereof. Therefore, a debris reduction apparatus (also referred to as a Debris Mitigation Tool (DMT)) has been proposed in order to trap dissipated debris so that debris does not enter the application apparatus, as disclosed in, for example, Patent Literature 1 (Laid-open Publication of Japanese Patent Application No. 2017-219698 A).

The debris reduction apparatus is equipped with a foil trap with multiple foils (i.e., thin sheets or thin flat plates) that are arranged to finely divide a space into smaller spaces.

In each of smaller spaces finely divided by the multiple foils, each of the smaller spaces performs the function to lower the conductance and increase the pressure in that smaller space concerned. As debris travels through each of the smaller spaces divided by those foils (i.e., area with increased pressure), it increases the probability of collision between the debris and ambient gas in the area with increased pressure. As a result, the debris is trapped by the debris reduction apparatus because the debris dispersal velocity is reduced and the direction in which the debris travels is changed.

The foil traps may be classified into two types: the static foil trap in which the position of multiple foils is fixed, and a rotary foil trap in which an action of active collision of the multiple foils with the debris is further added. The rotary foil trap includes multiple foils arranged radially in the radial direction around a centrally located rotation axis, and by rotating the multiple foils around the above rotation axis, causes the debris dispersed from the plasma to collide with the foils.

It should be noted that one debris reduction apparatus may be equipped with both the rotary foil trap and the static foil trap, or alternatively, only either one of the two types of the foil trap.

### LISTING OF REFERENCES

### PATENT LITERATURE

PATENT LITERATURE 1: Laid-open Publication of Japanese Patent Application No. 2017-219698 A

### SUMMARY OF THE INVENTION

### PROBLEMS TO BE SOLVED BY THE INVENTION

The inventor of the present invention has noticed that, during operation of the EUV light source apparatus and debris reduction operation by rotational operation of the rotary foil trap constituting the debris reduction apparatus, defects occur in some of rotary foil traps in which a part of multiple foils constituting the rotary foil trap ruptures after a relatively short period of operation.

The above defects occurred only in some of rotary foil traps. On the other hand, in a relatively large number of rotary foil traps, the above defects did not occur even after several times more hours of use than that of the rotary foil trap in which the above defects occurred.

For this reason, the present inventor considered that the above defects are unlikely to be caused due to the original operating life of the rotary foil traps, and that the defects might occur in the rotary foil traps manufactured in certain identical lots.

Therefore, the present inventor investigated the degree of occurrence of the defects in several rotary foil traps manufactured in an identical lot. As a result, it was turned out that such defects do not necessarily occur in all rotary foil traps manufactured in an identical lot (in particular, in the foils manufactured in an identical lot). More specifically, among the rotary foil traps manufactured in an identical lot, a part of foils ruptured after approximately 44 hours of operation in some rotary foil traps, while there were also some rotary foil traps without any rupture of the foils thereof even after approximately two months of operation.

The present invention has been made in order to solve the above mentioned problems and an object thereof is to provide a rotary foil trap that is arranged in the vicinity of the plasma to transmit light emitted from the plasma and to trap debris dispersed from the plasma, and is capable of having a relatively long-term operating life without causing any short-term defects such as rupture of foils, and also to provide a light source apparatus equipped with the rotary foil trap.

### SOLUTION TO PROBLEMS

In order to solve the above mentioned problems, according to one aspect of the present invention, there is provided a rotary foil trap arranged in a vicinity of plasma generated by a plasma generation unit and configured to rotationally operate to transmit light emitted from the plasma and to trap debris dispersed from the plasma, the rotary foil trap comprising: a plurality of foils; and a support member configured to support the plurality of foils, the plurality of foils each being made of a rolled thin plate that is tensile processed by rolling, and a direction of centrifugal force applied to the foils by rotational operation coinciding or approximately coinciding with a rolling direction, which is a direction in which the foils are tensile processed.

In this way, by setting the rolling direction of the foils to coincide with the direction of centrifugal force, it makes it possible to suppress the occurrence of defects such as rupture of the foils during the rotational operation of the rotary foil trap under environments subject to various loads such as thermal radiation from the plasma, collision with debris, and an exposure to light.

In the above rotary foil trap, an angle between the direction of the centrifugal force and the rolling direction may range between 0 degrees and 20 degrees.

In this case, it makes it possible to certainly suppress the occurrence of defects such as rupture of the foils during the rotational operation of the rotary foil trap.

Furthermore, in the above rotary foil trap, the plasma generation unit may be configured to excite a raw material emitting the light to generate the plasma, and the foils may rotationally operate at a temperature at or above a melting point of the raw material. In this case, it makes it possible to prevent debris from accumulating on the foils, because the raw material adhering to the foils (i.e., debris) is liquefied, and the debris, which has become droplets, moves in the radial direction of rotation by centrifugal force on the rotating foils and detaches out of the foils. As such, even when the rotary foil trap is being operated under such a high-temperature environment, it makes it possible to appropriately suppress the occurrence of defects such as rupture of the foils during the rotational operation.

Yet furthermore, in the above rotary foil trap, the rolling direction may be a direction in which crystal grains constituting the rolled thin plate are elongated.

In this case, it makes it possible to constitute the foils such that the longitudinal direction of the crystal grains thereof coincides or approximately coincides with the direction of the centrifugal force. The rolling direction of the foils may be readily identified using the Scanning Electron Microscope (SEM) or the like.

Yet furthermore, according to another aspect of the present invention, there is provided a light source apparatus comprising: the above rotary foil trap; and the plasma generation unit. Here, the light emitted from the plasma generation unit may be extreme ultraviolet light.

Accordingly, it makes it possible to configure the light source apparatus (e.g., extreme ultraviolet light source apparatus) to be equipped with the rotary foil trap with a relatively long operating life.

### ADVANTAGEIOUS EFFECT OF THE INVENTION

The rotary foil trap according to the present invention is a rotary foil trap that is arranged in the vicinity of the plasma to trap debris dispersed from the plasma, and according to the present invention, it makes it possible to allow the rotary foil trap to have a relatively long-term operating life without causing any short-term defects such as rupture of foils.

The above mentioned and other not explicitly mentioned objects, aspects and advantages of the present invention will become apparent to those skilled in the art from the following embodiments (detailed description) of the invention by referring to the accompanying drawings and the appended claims.

### BRIEF DESCRIPTION OF DRAWINGS

FIG. 1 is a schematic diagram illustrating an exemplary configuration of an extreme ultraviolet light source apparatus according to the present embodiment of the present invention.
FIG. 2 is a side cross-sectional view illustrating an exemplary configuration of a portion of the extreme ultraviolet light source apparatus.
FIG. 3 is a front view illustrating an exemplary configuration of a rotary foil trap.
FIG.4 is a top view illustrating an exemplary configuration of a static foil trap.
FIG. 5 is a front view illustrating an exemplary configuration of the static foil trap.
FIG. 6 is a conceptual diagram illustrating a rolling direction of a foil.
FIG. 7 is a conceptual diagram illustrating a longitudinal direction and a transverse direction of the foil.
FIG. 8A is a conceptual diagram illustrating an exemplary tensile test of a sample in the rolling direction.
FIG. 8B is a conceptual diagram illustrating another exemplary tensile test of a sample in a direction orthogonal to the rolling direction.
FIG. 9 is a schematic diagram illustrating the relationship between the rolling direction and a direction of centrifugal force.
FIG. 10 is a schematic diagram illustrating an angle between the rolling direction and the direction of the centrifugal force component.
FIG. 11 is a table illustrating exemplary results of the investigation of the allowable range of the angle between the rolling direction and the direction of the centrifugal force component.

### DESCRIPTION OF EMBODIMENTS

Hereinafter, non-limiting embodiments of the present invention will be described in detail with reference to the accompanying drawings.

It should be noted that the following embodiments are not intended to limit the present invention, and not all of the combinations of features described in the embodiments are necessarily essential for implementing the present invention. The configuration of the embodiments may be modified or changed as appropriate depending on the specifications of apparatuses to which the present invention is applied and various conditions (e.g., conditions of use, environment of use, and the like). The technical scope of the present invention shall be defined by the claims and is not limited by the following individual embodiments. In addition, the drawings referred to in the following description may differ from the actual structure, scale, shape, and the like, in order to make each configuration easier to understand.

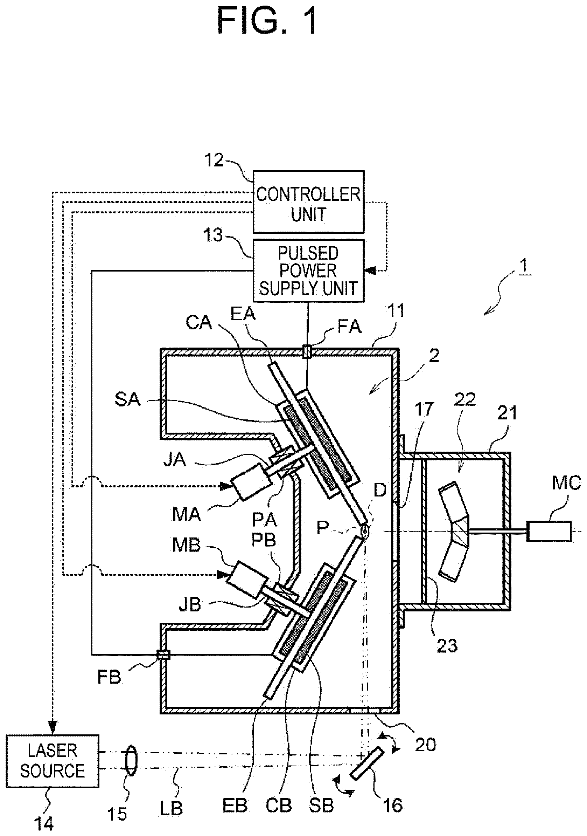

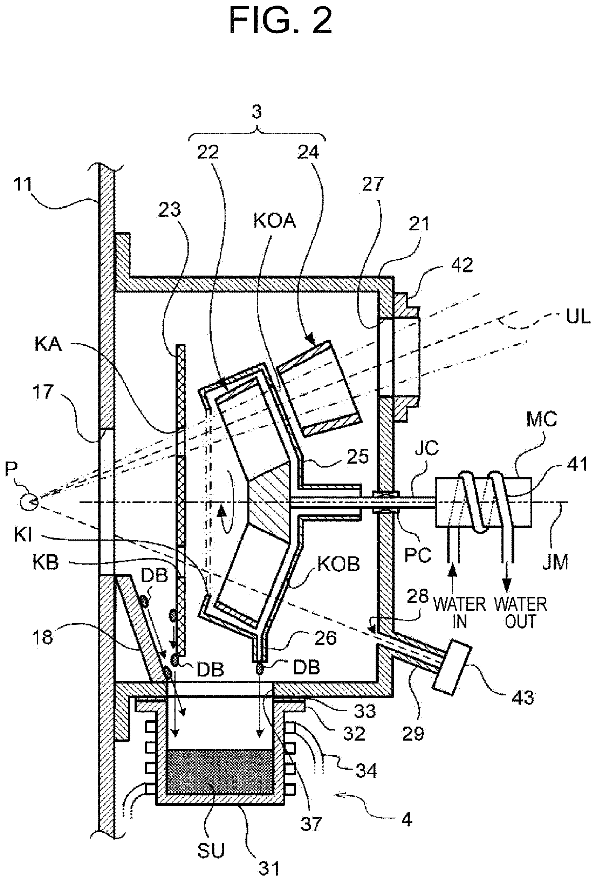

FIG. 1 is a cross-sectional view exemplarily illustrating the inside of a chamber and a connecting chamber of an extreme ultraviolet light source apparatus according to the present embodiment, when cut horizontally, and FIG. 2 is a cross-sectional view schematically illustrating an exemplary configuration of a debris reduction unit and a debris container unit. It should be noted that the present embodiment will exemplarily describe an extreme ultraviolet light source apparatus (i.e., EUV light source apparatus) of the LDP type method as a certain example.

Referring to FIG. 1, the EUV light source apparatus 1 emits extreme ultraviolet light (i.e., EUV light). The wavelength of this extreme ultraviolet light is, for example, 13.5 nm.

More specifically, the EUV light source apparatus 1 irradiates the plasma raw materials SA and SB in a liquid phase, which are supplied to surfaces of a pair of discharge electrodes EA and EB for generating the discharge, respectively, with energy beams such as laser beams LB, to vaporize the plasma raw materials SA and SB. Subsequently, the EUV light source apparatus 1 generates plasma P by the discharge in a discharge region D between the discharge electrodes EA and EB. EUV light is emitted from the plasma P.

The EUV light source apparatus 1 may be used, for example, as a light source apparatus for lithography equipment in manufacturing semiconductor devices or a light source apparatus for mask inspection apparatuses used in lithography. For example, when the EUV light source apparatus 1 is used as a light source apparatus for mask inspection apparatuses, a portion of the EUV light emitted from the plasma P is extracted and guided to the mask inspection apparatus. The mask inspection apparatus uses the EUV light emitted from the EUV light source apparatus 1 as inspection light to perform mask blank inspection or pattern inspection. By using the EUV light, the mask inspection apparatus may handle processes in the order of 5 to 7 nm. The EUV light extracted from the EUV light source apparatus 1 may be defined by an aperture KA arranged in a heat shielding plate 23 in FIG. 2.

As shown in FIGs. 1 and 2, the EUV light source apparatus 1 includes a light source unit 2, a debris reduction unit 3, and a debris container unit 4. The light source unit 2 generates EUV light according to the LDP type method. The debris reduction unit 3 traps debris dispersed along with the EUV light emitted from the light source 2. The debris container unit 4 contains the debris generated in the light source unit 2 and the debris trapped by the debris reduction unit 3.

The EUV light source apparatus 1 also includes a chamber 11 that isolates the plasma P generated inside from the outside. The chamber 11 is made from a rigid body, for example, metal. The chamber 11 is a vacuum enclosure, and the interior thereof is kept in a reduced pressure atmosphere in order to satisfactorily generate the discharge for heating and exciting the plasma raw materials SA and SB and to suppress the attenuation of the EUV light.

The light source unit 2 is arranged inside the chamber 11. The light source unit 2 is equipped with a pair of discharge electrodes EA and EB. The discharge electrodes EA and EB are disc-shaped members having the same shape and size, respectively. For example, the discharge electrode EA may be used as a cathode and the discharge electrode EB may be used as an anode. Each of the discharge electrodes EA and EB is made from, for example, high melting point metals such as molybdenum (Mo), tungsten (W) or tantalum (Ta). The discharge electrodes EA and EB are arranged at separate positions from each other, and the peripheral edges of the discharge electrodes EA and EB are in close proximity each other. The discharge region D in which plasma P is generated is positioned in a gap between the discharge electrodes EA and EB, where the peripheral edges of the discharge electrodes EA and EB are closest to each other.

By supplying power to the discharge electrodes EA and EB from the pulsed power supply unit 13, discharge occurs in the discharge region D. The plasma raw materials SA and SB, which are transported to the discharge region D along with the rotation of respective discharge electrodes EA and EB, are heated and excited by the current flowing between the discharge electrodes EA and EB during discharge, and plasma P emitting EUV light is generated.

The discharge electrode EA is connected to a rotation shaft JA of a motor MA and rotates around the axis line of the discharge electrode EA. Likewise, the discharge electrode EB is connected to a rotation shaft JB of a motor MB and rotates around the axis line of the discharge electrode EB. The motors MA and MB are arranged outside of the chamber 11, and the rotation shafts JA and JB of respective motors MA and MB extend from outside to inside of the chamber 11. The gap between the rotation shaft JA and a wall of the chamber 11 is sealed by a sealing member PA, and the gap between the rotation shaft JB and a wall of the chamber 11 is sealed by a sealing member PB. The sealing members PA and PB are, for example, mechanical seals, respectively. The sealing members PA and PB rotatably support the rotation shafts JA and JB, respectively, while maintaining a reduced pressure atmosphere in the chamber 11. Thus, respective discharge electrodes EA and EB are driven by individual motors MA and MB via the rotation shafts JA and JB, respectively. The rotational driving of those motors MA and MB is controlled by a controller unit 12.

Inside the chamber 11, a container CA in which a plasma raw material SA in the liquid phase is contained and a container CB in which a plasma raw material SB in the liquid phase is contained are arranged. Heated plasma raw materials SA and SB in the liquid phase are supplied to respective containers CA and CB, respectively. The plasma raw materials SA, SB in the liquid phase are, for example, tin.

The container CA contains the plasma raw material SA such that the lower portion of the discharge electrode EA is immersed in the plasma raw material SA in the liquid phase. Likewise, the container CB contains the plasma raw material SB such that the lower portion of the discharge electrode EB is immersed in the plasma raw material SB in the liquid phase. As a result, the plasma raw materials SA and SB in the liquid phase adheres to the lower portions of the discharge electrodes EA and EB, respectively. The plasma raw materials SA and SB in the liquid phase, which adhere to the lower portions of the discharge electrodes EA and EB, are transported to the discharge region D where the plasma P is generated as the discharge electrodes EA and EB rotate, respectively.

A laser source (e.g., energy beam irradiation device) 14 is arranged outside the chamber 11. The laser source 14 irradiates the plasma raw material SA, which is transported to the discharge region D and adheres to the discharge electrode EA, with energy beams to vaporize the plasma raw material SA. The laser source 14 may be, for example, a Nd:YVO₄ (Neodymium-doped Yttrium Orthovanadate) laser device. The laser source 14 emits a laser beam LB in the infrared region with a wavelength of 1064 nm. However, the energy beam irradiation device may be a device that emits energy beams other than the laser beam LB, as long as the energy beam irradiation device is capable of vaporizing the plasma raw material SA.

The timing of the laser beam LB irradiation by the laser source 14 is controlled by the controller unit 12. The laser beam LB emitted from the laser source 14 is guided to a movable mirror 16 through a condensing means including, for example, a condenser lens 15. The condensing means adjusts the spot diameter of the laser beam LB at the laser beam irradiation position of the discharging electrode EA. The condenser lens 15 and the movable mirror 16 are arranged outside the chamber 11.

The laser beam LB condensed by the condenser lens 15 is reflected by the movable mirror 16, passes through the transparent window 20 arranged in the wall of chamber 11, and is irradiated to the peripheral edge of the discharge electrode EA in the vicinity of the discharge region D.

Here, the to-be-irradiated position by the infrared laser beam LB at the discharge electrode EA is adjusted by adjusting the posture of the movable mirror 16. Adjusting the posture of the movable mirror 16 may be performed manually by an operator, or alternatively, the controller unit 12 may control the posture of the movable mirror 16 based on information of the EUV light intensity from a monitoring device 43, which will be described later. In this case, the movable mirror 16 is driven by a movable mirror driving unit, which is not shown in the figures.

To make it easier to irradiate the laser beam LB onto the peripheral edge of the discharge electrode EA in the vicinity of the discharge region D, the axis lines of the discharge electrodes EA and EB are set to be non-parallel to each other. The spacing between the rotation shafts JA and JB is narrower on the sides of the motors MA and MB and wider on the sides of the discharge electrodes EA and EB. This allows the opposing surfaces of the discharge electrodes EA and EB to be brought closer to each other, while the opposite sides to the opposing surfaces of the discharge electrodes EA and EB are evacuated from the irradiation path of the laser beam LB. This makes it easier to irradiate the laser beam LB onto the peripheral edge of the discharge electrode in the vicinity of the discharge region D.

The discharge electrode EB is arranged between the discharge electrode EA and the movable mirror 16. The laser beam LB reflected by the movable mirror 16 passes near the outer surface of the discharge electrode EB and then reaches the outer surface of the discharge electrode EA. At this time, the discharge electrode EA is evacuated toward the direction of the motor MB side (i.e., left side of FIG. 1) from the discharge electrode EA in order to prevent the laser beam LB from being shielded by the discharge electrode EB.

The plasma raw material SA in the liquid phase, which has adhered to the outer surface of the discharge electrode EA in the vicinity of the discharge region D, is vaporized by the laser beam LB irradiation and supplied to the discharge region D as a plasma raw material SA in a gas phase.

In order to satisfactorily generate plasma P in the discharge region D (i.e., to plasmatize the plasma raw material SA in the gas phase), the pulsed power supply unit 13 supplies power to the discharge electrodes EA and EB. When the plasma raw material SA in the gas phase is supplied to the discharge region D by the laser beam LB irradiation, a discharge occurs between the discharge electrodes EA and EB in the discharge region D. At this time, the pulsed power supply unit 13 periodically supplies pulsed power to the discharge electrodes EA and EB.

The pulsed power supply unit 13 is arranged outside of chamber 11. Feeder lines extending from the pulsed power supply unit 13 pass through feedthroughs FA and FB and extend into the interior of the chamber 11. The feedthroughs FA and FB are sealing members that are embedded in the wall of the chamber 11 and maintain a reduced pressure atmosphere inside the chamber 11, respectively. The operations of the laser source 14 and the pulsed power supply unit 13 for generating the plasma P are controlled by the controller unit 12.

Two feeder lines extending from the pulsed power supply unit 13 are connected to the containers CA and CB via the feedthroughs FA and FB, respectively. The containers CA and CB are made from conductive materials, respectively, and the plasma raw materials SA and SB contained inside respective containers CA and CB are also conductive materials such as tin. The lower portions of the discharge electrodes EA and EB are immersed in the plasma raw materials SA and SB contained inside respective containers CA and CB, respectively. Therefore, when pulsed power is supplied to the containers CA and CB from the pulsed power supply unit 13, the pulsed power is then supplied to the discharge electrodes EA and EB through the plasma raw materials SA and SB, respectively. When the discharge occurs between the discharge electrodes EA and EB, the plasma raw material SA in the gas phase in the discharge region D is heated and excited by the electric current so as to generate the plasma P.

EUV light is emitted from the plasma P. The EUV light is used by various application apparatuses, serving as other optical system apparatuses, such as lithography equipment or mask inspection apparatuses. According to the present embodiment, the EUV light is assumed to be used in the mask inspection apparatus.

A connecting chamber 21 is arranged between the chamber 11 and the application apparatus. The connecting chamber 21 is made from a rigid body, for example, metal. The connecting chamber 21 is a vacuum enclosure, and the interior thereof, similarly to the interior of the chamber 11, is kept in a reduced pressure atmosphere in order to suppress the attenuation of the EUV light.

The interior space of the connecting chamber 21 communicates with the chamber 11 through a window 17, which is a through hole formed in the wall of the chamber 11. The interior space of the connecting chamber 21 also communicates with the application apparatus (e.g., mask inspection apparatus) 42 through a window 27, which is a through hole formed in the wall of the connecting chamber 21. FIG. 2 shows only a portion of the application apparatus 42. The EUV light emitted from the plasma P in the discharge region D is introduced into the application apparatus (e.g., mask inspection apparatus) 42 through the windows 17 and 27.

On the other hand, debris DB is dispersed from the plasma P at high speed in various directions along with the emitted EUV light. The debris DB includes tin particles, which are plasma raw materials SA and SB, and material particles of discharge electrodes EA and EB, which are sputtered during the generation of the plasma P.

The debris DB acquires large kinetic energy through the contraction and expansion processes of the plasma P. In other words, the debris DB generated from the plasma P contains ions, neutral atoms, and electrons, which are travelling at high speed, and when such debris DB reaches the application apparatus 42, the debris DB is likely to damage or contaminate the reflective film of optical elements in the application apparatus 42, thereby deteriorating the performance thereof.

For this reason, according to the present embodiment, the debris reduction unit 3 is provided in the connecting chamber 21 to trap debris DB in order to prevent debris DB from entering the application apparatus 42. The debris reduction unit 3 includes the static foil trap in which the position of multiple foils is fixed, and a rotary foil trap in which an action of active collision of the multiple foils with the debris is further added. The static foil trap 24 is arranged between the rotary foil trap 22 and the application apparatus 42 in the optical path of EUV light traveling from the connecting chamber 21 to the application apparatus (e.g., mask inspection apparatus) 42. It should be noted that one debris reduction unit 3 may be equipped with both of the rotary foil trap 22 and the static foil trap 24, or alternatively, either one of the rotary foil trap 22 or the static foil trap 24.

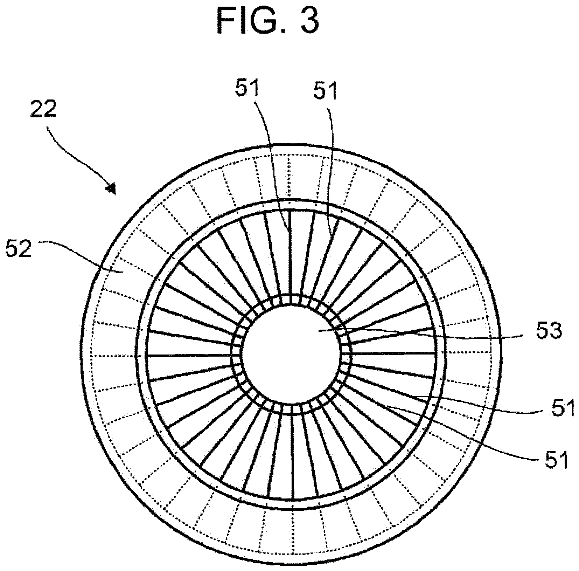

FIG. 3 is a front view illustrating an exemplary configuration of the rotary foil trap shown in FIG. 2.

Referring to FIG. 3, the rotary foil trap 22 includes multiple foils (i.e., blades) 51, an outer ring 52, and a central hub (i.e., support member) 53. The outer ring 52 is concentric with the central hub 53 (hereinafter also simply referred to as hub), and each of the blades 51 is arranged between the outer ring 52 and the hub 53. Here, each of the blades 51 is a thin sheet or a thin flat plate. Respective blades 51 are arranged radially with approximately equal angular spacing. Each of the blades 51 is on a plane including the central axis line JM of the hub 53. The material of the rotary foil trap 22 is, for example, a high melting point metal such as tungsten and/or molybdenum.

The multiple blades 51 of the rotary foil trap 22 are positioned parallel to the ray direction of the EUV light traveling toward the window 27 so as not to shield the EUV light traveling from the plasma P (i.e., luminous point) toward the window 27.

In other words, as shown in FIG. 2, the rotary foil trap 22, in which each of the blades 51 thereof is arranged on the plane including the central axis line JM of the hub 53, is arranged such that the plasma P (i.e., luminous point) lies on the extension line of the central axis line JM of the hub 53. This makes it possible to shield EUV light only by the thicknesses of respective blades 51, except for the hub 53 and the outer ring 52, so as to maximize the ratio of EUV light (hereinafter also referred to as transmittance) that passes through the rotary foil trap 22.

The hub 53 is connected to the rotation shaft JC of the motor (i.e., rotary driving unit) MC, and the central axis line JM of the hub 53 coincides with the central axis line of the rotation shaft JC. Here, the rotation shaft JC of the motor MC may be assumed to be the rotation axis of the rotary foil trap 22. The rotary foil trap 22 rotates driven by the motor MC, and the rotating blades 51 collide with the debris DB arriving from the plasma P to trap the debris DB so as to prevent the debris DB from entering the application apparatus 42.

The rotary foil trap 22 is arranged inside the connecting chamber 21, whereas the motor MC is arranged outside the connecting chamber 21. The wall of the connecting chamber 21 is provided with a through hole through which the rotation shaft JC passes. The gap between the rotation shaft JC and the wall of the connecting chamber 21 is sealed by a sealing member PC made of, for example, a mechanical seal. The sealing member PC rotatably supports the rotation shaft JC of the motor MC while maintaining a reduced pressure atmosphere in the connecting chamber 21.

The rotary foil trap 22 becomes hot due to radiation from the plasma P. Therefore, in order to prevent the rotary foil trap 22 from being overheated, in some cases, the rotation shaft JC may be made hollow to distribute cooling water to cool the rotary foil trap 22. Since the motor MC itself also generates heat during rotation, water-cooling piping 41 may be wrapped around the motor MC to remove heat. Water flows through the water-cooling piping 41 to cool the motor MC through heat exchange.

Furthermore, in order to reduce radiation from the plasma P to the rotary foil trap 22 and to prevent the rotary foil trap 22 from being overheated, the heat shielding plate 23 is arranged in the connecting chamber 21. The heat shielding plate 23 is provided with an aperture KA having an arbitrary shape (e.g., circular shape) for extracting a portion of the EUV light emitted from the plasma P. Since the heat shielding plate 23 is arranged in the vicinity of the plasma P, the heat shielding plate 23 is made from a high melting point material such as molybdenum or tungsten, for example.

The aperture KA is arranged at a position eccentric from the rotation axis JM of the rotary foil trap 22. Here, a portion of the EUV light emitted from the plasma P is extracted from the heat shielding plate 23 through the aperture KA at a predetermined solid angle with respect to the direction of the rotation axis of the rotary foil trap 22 (i.e., right and left directions in FIG. 2).

The rotary foil trap 22 is arranged such that the blades 51 lie on the main beam UL of the EUV light beam flux passing through the aperture KA of the heat shielding plate 23 (hereinafter also referred to as EUV extraction light). The EUV light extracted from the aperture KA of the heat shielding plate 23 passes through the debris reduction unit 3 and is introduced into the application apparatus (e.g., mask inspection apparatus) 42 through the window 27.

The rotary foil trap 22 traps relatively slow debris DB among the debris DB dispersed from the plasma P, while the static foil trap 24 traps fast-travelling debris DB that could not be trapped by the rotary foil trap 22 among the debris DB dispersed from the plasma P. As shown in FIG. 2, the static foil trap 24 is positioned on the main beam UL of the EUV extraction light.

Also, the static foil trap 24 has a shape corresponding to a region through which the EUV extraction light, which is EUV light of which direction of travel is restricted by the aperture KA of the heat shielding plate 23, passes.

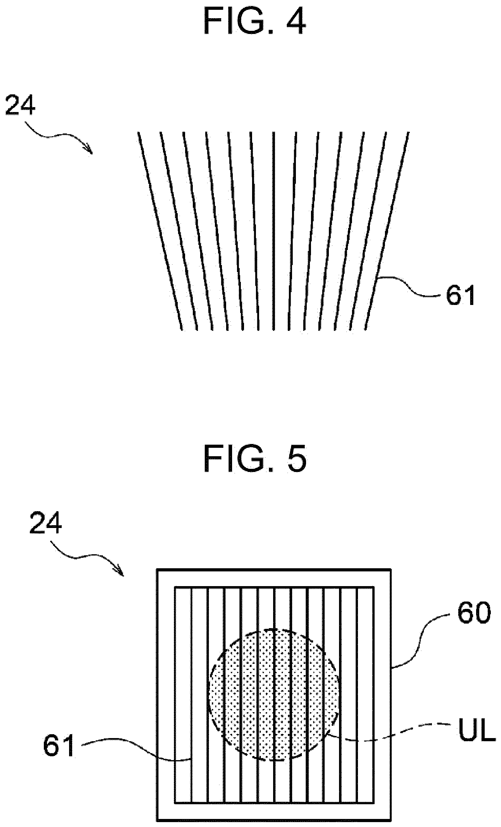

FIG. 4 is a top view illustrating an exemplary configuration of the static foil trap shown in FIG. 2, and FIG. 5 is a cross-sectional view illustrating an exemplary configuration of the static foil trap shown in FIG. 2.

Referring to FIGs. 4 and 5, the static foil trap 24 includes multiple foils 61 and a fixing frame (i.e., fixing member) 60 that supports the foils 61.

The foils 61 are arranged at equal intervals in a cross-section orthogonal to the direction of the main beam UL of the EUV extraction light, as shown in FIG. 5. The fixing frame 60 is, for example, rectangular in shape when viewed from the front. The external shape of the fixing frame 60 may be of any arbitral shape. Furthermore, the multiple foils 61 are arranged radially such that the foils 61 extend in the ray direction of the EUV extraction light when viewed from a direction orthogonal to the main beam UL direction, as shown in FIG. 4.

The multiple foils 61 of the static foil trap 24 finely divide a space where the static foil trap 24 is arranged into smaller sections, thereby acting to lower the conductance in that area and increase the pressure locally. By supplying gas to the static foil trap 24 as needed, the pressure in the static foil trap 24 is increased. In other words, in the connecting chamber 21, the gas is localized in the static foil trap 24 to set up an area in the connecting chamber 21 where the pressure is relatively high. Here, the gas to be supplied to the static foil trap 24 may be preferably gas with higher transmittance for EUV light, for example, noble gas such as helium (He), argon (Ar), or hydrogen (H₂).

High-speed debris DB that could not be trapped in the rotary foil trap 22 decreases its velocity due to the increased probability of collision with the gas in the area of increased pressure in the static foil trap 24. The collision with the gas also changes the direction of travel of the debris DB. The static foil trap 24 traps the debris DB of which velocity is reduced and of which direction of travel is changed in this way by the foils 61 or the fixing frame 60.

A cover member 25 is arranged inside the connecting chamber 21. The cover member 25 encloses the rotary foil trap 22 and prevents debris DB trapped by the rotary foil trap 22 from scattering into the interior of the connecting chamber 21. The cover member 25 is equipped with a light-incident side aperture KI and light-exit side apertures KOA and KOB. The light-incident side aperture KI is arranged at a position where the EUV light entering the rotary foil trap 22 is not shielded. The light-exit side aperture KOA is arranged at a position where the EUV light entering the static foil trap 24 is not shielded after passing through the light-incident side aperture KI and the rotary foil trap 22. Likewise, the light-exit side aperture KOB is arranged at a position where the EUV light entering the monitoring device 43 is not shielded after passing through the light-incident side aperture KI and the rotary foil trap 22.

At least some of the debris DB trapped by the rotary foil trap 22 travels in the radial direction on the blades 51 of the rotary foil trap 22 due to centrifugal force, detaches from the edge of the blades 51, and adheres to the inner surface of the cover member 25.

The cover member 25 is heated by secondary radiation from the heating means, which is not shown in the figures, or the heat shielding plate 23 that receives EUV radiation. For this reason, the debris DB adhering to the inner surface of the cover member 25 is not solidified by the heating and remains in the liquid phase. The debris DB adhering to the inner surface of the cover member 25 collects at the bottom of the cover member 25 due to gravity, and is discharged from the bottom of the cover member 25 through the discharge pipe 26 to the outside of the cover member 25 to become waste material, and is eventually contained in the debris container unit 4. This allows the cover member 25 to prevent debris DB that has detached from the edges of the blades 51 of the rotary foil trap 22 from scattering into the interior of the connecting chamber 21.

The debris container unit 4 is equipped with a debris containment vessel 31. The debris containment vessel 31 is arranged outside the connecting chamber 21 and is attached to the connecting chamber 21. The debris containment vessel 31 stores the containment SU including the debris DB and the waste material.

A through hole 37 is formed in the bottom wall of the connecting chamber 21 that connects the interior space of the debris containment vessel 31 to the interior space of the connecting chamber 21. The debris containment vessel 31 is equipped with a flange 32 at the top thereof. The opening of the debris containment vessel 31 surrounded by the flange 32 overlaps the through hole 37 of the connecting chamber 21. The debris containment vessel 31 is then attached to the connecting chamber 21 by fixing the flange 32 to the bottom wall of the connecting chamber 21, for example, with screws. The gap between the flange 32 and the bottom wall of the connecting chamber 21 is sealed by a gasket 33. The heat shielding plate 23 is arranged above the through hole 37 in an upright position. The outlet of the discharge pipe 26 is arranged above the through hole 37. The debris containment vessel 31 is arranged at the position where the debris DB drops from the heat shielding plate 23 and the discharge pipe 26.

The waste material discharged out of the cover member 25 through the discharge pipe 26 drops in the direction of gravity and accumulates in the debris containment vessel 31, which is arranged below the connecting chamber 21 (bottom side of FIG. 2). On the other hand, some of the debris DB dispersed from the plasma P in various directions enters the connecting chamber 21 through the window 17 of the chamber 11 and is then deposited on the surface facing the window 17 of the heat shielding plate 23. The debris DB deposited on the heat shielding plate 23 melts due to radiation from the plasma P, and when the melted debris DB reaches a certain amount, the debris DB turns into droplets and moves downwardly on the heat shielding plate 23 by gravity. The debris DB, which has moved downwardly below the heat shielding plate 23, detaches from the heat shielding plate 23 and drops below the connecting chamber 21, where the debris DB is contained in the debris containment vessel 31.

In this way, the heat shielding plate 23 limits the EUV radiation from the plasma P to the rotary foil trap 22 to prevent the rotary foil trap 22 from being overheated and extracts a portion of the EUV light emitted from the plasma P through the aperture KA. Furthermore, according to the present embodiment, the heat shielding plate 23 reduces the debris DB traveling toward the rotary foil trap 22 as little as possible so as to reduce the load on the rotary foil trap 22.

Meanwhile, in the EUV light source apparatus 1 of the LDP type method, in some cases, some of the plasma raw material (e.g., tin) SA and SB supplied to the discharge unit (i.e., discharge electrodes EA and EB, and the like) may leak out. For example, some of the plasma raw materials SA and SB may leak from the containers CA and CB. The leaked plasma raw materials SA and SB do not contribute to generating the plasma P and thus become the waste material. The plasma raw materials SA and SB leaked from the discharge unit described above are collected by an enclosure member, which is not shown in the figures.

In order to guide the plasma raw materials SA and SB collected as the waste material by the enclosure member into the debris containment vessel 31, a receiving plate member (e.g., shovel) 18 is installed in the connecting chamber 21. The receiving plate member 18 is supported in an inclined posture such that the receiving plate member 18 is hung from the window 17 to the through hole 37. The receiving plate member 18 is heated by a heating means (i.e., heater), which is not shown in the figures, such that the plasma raw materials SA and SB collected as the waste material are maintained above their melting points on the receiving plate member 18. Subsequently, the plasma raw materials SA and SB collected as the waste material by the enclosure member and some of the debris DB that has entered the connecting chamber 21 are guided by the receiving plate member 18 and drop into the debris containment vessel 31.

Here, since most of the debris DB is tin and the waste material is also tin, the debris containment vessel 31 may be referred to as a tin recovery vessel. A heater wiring 34 is wrapped around the debris containment vessel 31, as heating means to heat the debris containment vessel 31. The heating means may be embedded in a body of the debris containment vessel 31.

During operation of the EUV light source apparatus 1, the inside of the debris containment vessel is heated at or above the melting point of tin by supplying power to the heater wiring 34, and the tin accumulated inside the debris containment vessel 31 is turned to the liquid phase.

The reason why the tin inside the debris containment vessel 31 is to be in the liquid phase is that, when the debris DB accumulated inside the debris containment vessel 31 solidifies, the accumulation of debris DB at the position where the debris DB tends to drop down grows as if the debris DB were stalagmites in a stalactite cave. When the debris DB accumulation grows like a stalagmite, for example, the discharge pipe 26 of the cover member 25 is sealed by the grown debris DB, and the debris DB accumulates inside the cover member 25. At this time, at least some of the debris DB accumulated in the cover member 25 is likely to contact the rotary foil trap 22, which may prevent the rotary foil trap 22 from rotating or even damage the rotary foil trap 22.

Alternatively, a part of the light-exit side apertures KOA and KOB provided in the cover member 25 may be blocked by the debris DB accumulated in the cover member 25, and a portion of the EUV light passing through the light-exit side apertures KOA and KOB may be shielded.

For this reason, by causing tin to be in the liquid phase, which is the inner containment of the debris containment vessel 31, it makes it possible to flatten tin in the debris containment vessel 31 and store tin in the debris containment vessel 31 while avoiding stalagmite-like growth of tin.

When recovering the tin accumulated in the debris containment vessel 31, the heating inside the debris containment vessel 31 is stopped by stopping the power supply to the heater wiring 34. Subsequently, after the temperature of the debris containment vessel 31 reaches room temperature and the tin stored in the debris containment vessel 31 solidifies, the inside of the connecting chamber 21 is returned to atmospheric pressure. The debris containment vessel 31 is then removed from the connecting chamber 21, and a new debris containment vessel without tin accumulation is attached to the connecting chamber 21 instead.

Although tin inside the debris containment vessel 31 removed from the connecting chamber 21 is in the solid phase, the tin can be removed from the debris containment vessel 31 by reheating the debris containment vessel 31 to cause the tin inside the debris containment vessel 31 to be in the liquid phase again. The debris containment vessel 31 is reusable, once the debris containment vessel 31 is removed from the connecting chamber 21 and tin is removed from the inside thereof.

In addition, the monitoring device 43 that monitors EUV light is arranged outside of the connecting chamber 21. The monitoring device 43 is a detector that detects EUV light or a measurement device that measures the intensity of EUV light. An EUV light guide hole 28, which is a through hole through which EUV light passes, is formed in the wall of the connecting chamber 21, and a guide tube 29 through which EUV light passes without leaking outside the connecting chamber 21 is provided between the EUV light guide hole 28 and the monitoring device 43.

The heat shielding plate 23 is provided with an aperture KB having an arbitrary shape (e.g., circular shape) that extracts a portion of EUV light emitted from the plasma P at a different position from the aperture KA.

The monitoring device 43, the EUV light guide hole 28, and the guide tube 29 are positioned on the extension of the straight line connecting the plasma P and the center of the aperture KB. Therefore, a portion of EUV light emitted from the plasma P successively passes through the window 17 of the chamber 11, the aperture KB of the heat shielding plate 23, the light-incident side aperture KI of the cover member 25, the gap between the multiple blades 51 of the rotary foil trap 22, the light-exit side aperture KOB of the cover member 25, the EUV light guide hole 28 of the wall of the connecting chamber 21, and the interior of the guide tube 29 in turn to reach the monitoring device 43. In this way, it makes it possible to monitor EUV light by the monitoring device 43.

As mentioned above, the rotary foil trap 22 include the multiple foils (i.e., blades) 51 arranged radially with approximately equal angular spacing. Each of the blades 51 is a thin sheet or thin flat plate made from a high melting point metal. More specifically, each of the blades 51 is made of a thin molybdenum plate produced, for example, by tensile processing with multiple rolls, and its thickness is, for example, 0.1 to 0.3 mm. It should be noted that the blade 51 may also be made of a rolled thin plate of tungsten.

Conventionally, in the rotary foil trap with multiple foils (i.e., blades) as described above, in some cases, defects may occur in which a part of the blades may be ruptured, for example, in the vicinity of the hub (i.e., rotation axis) after a relatively short period of operation. Here, the term "operation" means that the rotary foil trap is rotationally operated to trap debris during the operation of the EUV light emission in the EUV light source apparatus.

The above defects occurred only in some of rotary foil traps. On the other hand, in a relatively large number of rotary foil traps, the above defects did not occur even after several times more hours of use than that of the rotary foil trap in which the above defects occurred. For this reason, the present inventor considered that the above defects were unlikely to be caused due to the original operating life of the rotary foil traps, and that the defects might occur in the rotary foil traps manufactured in certain identical lots. Therefore, the present inventor investigated the degree of occurrence of the defects in several rotary foil traps manufactured in an identical lot. As a result, it was turned out that such defects do not necessarily occur in all rotary foil traps manufactured in an identical lot (in particular, in the blades manufactured in an identical lot).

The present inventor further investigated rotary foil traps manufactured in the identical lot to determine the relationship between the rolling direction of the rolled thin plates of high melting point metal constituting the blades and the shape of the blades.

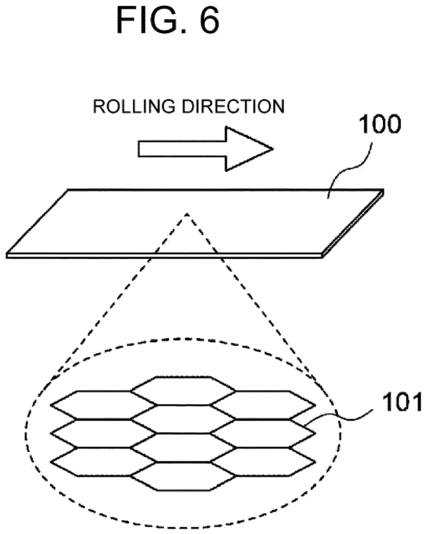

Hereinafter, the direction in which the thin plate is tensile processed by rolling is referred to as the "rolling direction". More specifically, "rolling direction" refers to the direction in which the crystal grains 101 of the metallic rolled thin plate 100 are elongated (i.e., the longitudinal direction of the crystal grains 101), as shown in FIG. 6. In case that multiple rolling is performed by changing the direction of tensile processing, the direction in which the crystal grains 101 are more elongated is referred to as the rolling direction.

The crystal structure of the metallic rolled thin plate 100 may be readily observed using the SEM (Scanning Electron Microscope) or other means.

As a result of the investigation of blades (i.e., long pieces) obtained from molybdenum rolled thin plates manufactured in the identical lot, it was turned out that there was a mixture of blades in which the longitudinal direction of the blade coincides with the rolling direction and blades in which the transverse direction of the blade coincides with the rolling direction.

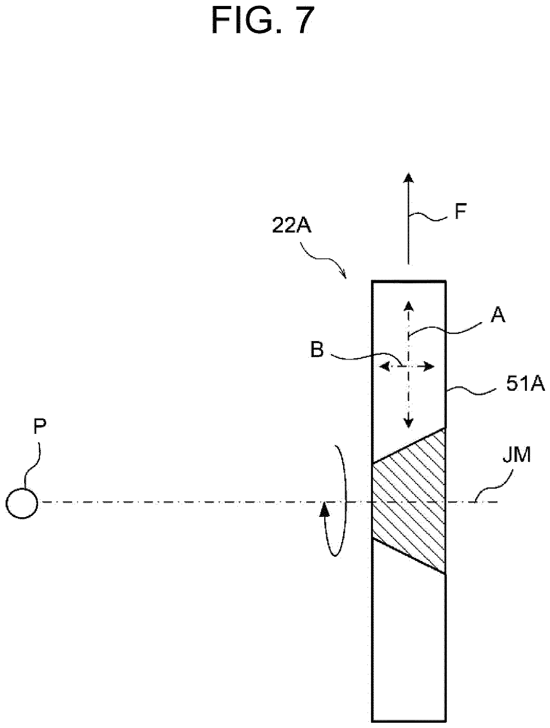

Here, as schematically shown in the rotary wheel trap 22A in FIG.7, the longitudinal direction of the blade refers to a direction of the long side of the blade 51A, which is the direction A approximately orthogonal to the rotation axis JM of the rotary foil trap 22A. On the other hand, the transverse direction of the blade refers to a direction of the short side of the blade 51A, which is the direction B approximately parallel to the rotational axis JM of the rotary foil trap 22A.

When the present inventor investigated the blades that caused defects among several rotary foil traps manufactured in the identical lot, it was turned out that the rolling direction of all the blades that caused defects, such as rupture, approximately coincides with the transverse direction of the blades.

The force applied to each of blades of the rotary foil trap during the rotational operation of the rotary foil trap is centrifugal force. Here, the direction of the centrifugal force is parallel to the longitudinal direction A of the blades. When the longitudinal direction A of the blades is orthogonal to the rotation axis JM, as in the rotary foil trap 22A shown in FIG. 7, the direction of the centrifugal force is a direction F, which is orthogonal to the rotation axis JM and is directed outwardly from the rotation axis JM.

In other words, it was turned out that in case that the rolling direction of the blade is approximately orthogonal to the direction of the centrifugal force F acting on the blade when the rotary foil trap is rotationally operating, defects occur such as rupture of the blade along with the rotary motion of the rotary foil trap.

Taking the above observations into consideration, it may be presumed that it is more likely to be able to suppress the occurrence of the above defects in case that, when the blade of the rotary foil trap is made of a rolled thin plate of high melting point metal, the rolling direction of the rolled thin plate constituting the blade coincides with the direction of the centrifugal force acting on the blade during the rotational operation of the rotary foil trap as much as possible, as compared to the case the above two directions do not coincide (e.g., orthogonal to each other).

In order to verify the above hypothesis, the present inventor conducted tensile tests on rolled thin plates of high melting point metal formed by tensile processing by rolling in the direction in which the thin plate was tensile processed by rolling (i.e., rolling direction) and also in the non-rolling direction, and examined the tensile strength of respective ones. In those tensile tests, the non-rolling direction was defined as the direction orthogonal to the rolling direction. A rolled thin plate of molybdenum with a thickness of 0.15 mm was used as the metallic rolled thin plate serving as the test sample for the tensile test.

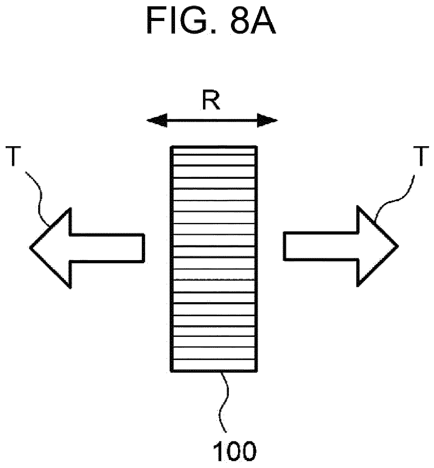

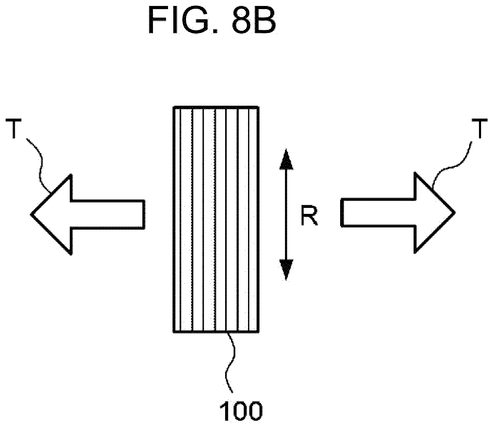

FIG. 8A is a schematic diagram illustrating a tensile test of a metallic rolled thin plate 100 in the rolling direction R, while FIG. 8B is a schematic diagram illustrating another tensile test of a metallic rolled thin plate 100 in a direction orthogonal to the rolling direction R.

As shown in FIG. 8A, as a result of the tensile test in the rolling direction R, the maximum value of the tensile test force T until the metallic rolled thin plate 100 was ruptured was 1.22 kN, and the tensile strength was 801 MPa. On the other hand, as shown in FIG. 8B, as a result of the tensile test in the direction orthogonal to the rolling direction R, the maximum value of the tensile test force T until the metallic rolled thin plate 100 was ruptured was 1.04 kN and tensile strength was 680 MPa.

In other words, the tensile strength in the rolling direction R is approximately 120 MPa higher than the tensile strength in the direction orthogonal to the rolling direction R.

At the same time, it was also turned out that not only the maximum value of the tensile test force T in the rolling direction R, 1.22 kN, but also the maximum value of the tensile test force T in the direction orthogonal to the rolling direction R, 1.04 kN, is significantly larger than the magnitude of the centrifugal force applied to each of the blades during the rotational operation of the rotary foil trap.

The magnitude of centrifugal force applied to each of the blades during the rotational operation of the rotary foil trap is, by calculation, approximately 60 N.

Therefore, the above defects are considered not due to mere centrifugal force alone but are considered to be defects that occur during light emission that are specific to EUV light source apparatus.

In fact, when the present inventor investigated the occurrence of defects by rotating the rotary foil trap alone without any EUV light emitting operation, no defects were confirmed such as rupture of the blades even when the centrifugal force direction F acting on the blade did not coincide with the rolling direction R of the blade (e.g., even when both directions were orthogonal to each other).

As shown in FIGs. 1 and 2, the rotary foil trap 22, which is a portion of the debris reduction device, is arranged in the connecting chamber 21. The position of the rotary foil trap 22 is relatively close to the plasma P generated in the chamber 11, thus the rotary foil trap 22 receives heat radiated from the plasma P. Therefore, the temperature of the rotary foil trap 22 becomes high during the operation of the EUV light source apparatus 1.

As described above, the heat shielding plate 23 is arranged in the connecting chamber 21 in order to prevent the rotary foil trap 22 from being overheated. When observing respective blades of molybdenum (Mo) of the rotary foil trap 22 after the EUV light source apparatus 1 was stopped, it was turned out that recrystallization of Mo had not yet occurred. This indicates that the temperature of the rotary foil trap 22 is kept below the recrystallization temperature of Mo by the heat shielding plate 23.

On the other hand, the debris (e.g., tin) trapped by each of the blades 51 travels outwardly in the redial direction on the 51 blades of the rotary foil trap 22 by centrifugal force without solidifying, detaches from the edges of the blades 51, and adheres to the inner surface of the cover member 25. Therefore, it means that the rotary foil trap 22 is kept at a temperature higher than the melting point of tin (approximately 232 degrees Celsius).

In other words, the temperature of the rotary foil trap 22 is considered to be 250 to 800 degrees Celsius.

Furthermore, as described above, each of the blades 51 of the rotary foil trap 22 collides with debris. The debris has already acquired large kinetic energy through the contraction and expansion processes of the plasma P, and the fast neutral atoms and other particles contained in the debris collide with each of the blades 51.

Yet furthermore, plasma P is generated when electrical energy is injected into the plasma raw material (e.g., tin) by the discharge between electrodes to excite the plasma raw material. In those processes, as the plasma raw material is excited to various levels, the plasma P emits not only EUV light but also light with various wavelengths.

Thus, during the operation of the EUV light source apparatus, each of the blades of the rotary foil trap is subjected to various loads: thermal radiation from the plasma P, collision with debris containing fast neutral atoms (e.g., tin), and exposure to EUV light and other wavelengths of light.

For this reason, when the direction of the centrifugal force acting on the blade is different from the rolling direction of the blade (e.g., orthogonal to the rolling direction), it may be assumed that defects occurred such as rupture of blades after a relatively short period of operation due to the above load in addition to the relatively weak tensile strength of the blade. Since the rupture of the blade occurred in the vicinity of the hub (i.e., rotation axis), which is not directly exposed to EUV light, it may be assumed that heat and debris (especially heat) have the most significant impact thereon among the above loads.

As described above, the present inventor has come to novel findings that in a rotary foil trap that is arranged in a high-temperature environment near the plasma and rotationally operates to transmit light emitted from the plasma and traps debris dispersed from the plasma, the specific defects such as rupture of foils occurs within a short period of time when the rolling direction of the blade is different from the direction of centrifugal force acting on the blade (e.g., orthogonal or approximately orthogonal). The present inventor also found that the above defects can be suppressed by making the rolling direction of the blade coincide with the direction of the centrifugal force acting on the blade.

It should be noted that the rotary foil trap is not necessarily configured such that the longitudinal direction A of the blade is orthogonal to the rotation axis JM as shown in FIG. 7.

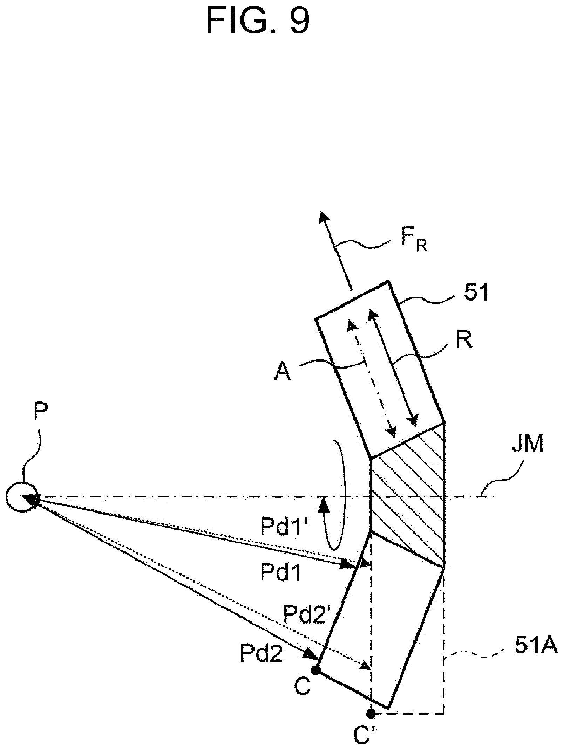

For example, the blade 51 may be arranged such that the longitudinal direction A of the blade is oblique to the rotation axis JM, as in a rotary foil trap 22 shown in solid line in FIG. 9. In this case also, preferably, the rolling direction R of the blade 51 coincides with a component of the centrifugal force direction F_{R} (i.e., longitudinal direction A of the blade) acting on the blade 51, as shown in FIG. 9.

In the case of the rotary foil trap 22 having a configuration in which the blades 51 are arranged such that the longitudinal direction A of the blades is oblique to the rotation axis JM as shown above, it makes it possible to increase the probability of debris capture by the blades arranged at a position farther from the rotation axis JM, as compared to the rotary foil trap 22A shown in FIG. 7. Hereinafter, this point will be described in detail below.

In the blade 51 configured such that the longitudinal direction of the blade is oblique to the rotation axis JM, as shown by the solid line in FIG. 9, the edge of the blade at the plasma P-side is closer to the plasma P, as compared to the blade 51A configured such that the longitudinal direction of the blade is orthogonal to the rotation axis JM, as shown by the dashed line in FIG. 9. At the position closer to the rotation axis JM, the difference between the distance Pd1', which is a distance from the plasma P to the edge of the blade 51A at the plasma P-side, and the distance Pd1, which is a distance from the plasma P to the edge of the blade 51 at the plasma P-side, is small. On the other hand, at the position farther from the rotation axis JM, the distance Pd2 becomes much shorter with respect to the distance Pd2'. For this reason, when the longitudinal direction of the blade is arranged to be oblique to the rotation axis JM, as shown by the solid line in FIG. 9, the spacing between adjacent blades at a position farther from the rotation axis JM is, when viewed from the plasma P, narrower than when the longitudinal direction of the blade is arranged to be orthogonal to the rotation axis JM, as shown by the dashed line in FIG. 9. Accordingly, it makes it possible to increase the probability of debris capture by the blades at a position farther from the rotation axis JM.

As described above, it is preferable that the rolling direction of the blades, which are the rolled thin plates constituting the rotary foil trap, coincides with the component of the centrifugal force direction applied to the blades during the rotational operation of the rotary foil trap. However, the relationship between the shape of each of blades and the rolling direction is not necessarily the desired relationship in manufacturing each of blades.

Here, the desired relationship refers to a relationship in which, when each of blades is attached to a rotary foil trap and being rotationally operated, the rolling direction of blade coincides with the component of the centrifugal force direction acting on the blade.

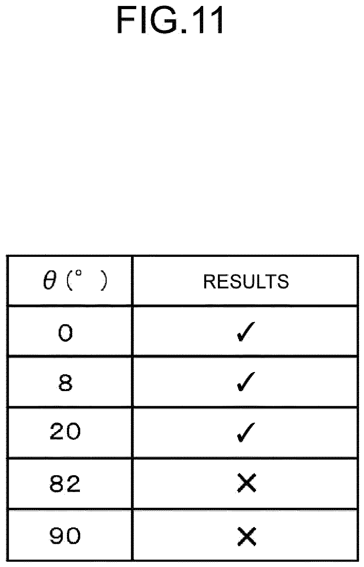

Therefore, the present inventor investigated to what extent the discrepancy between the rolling direction of the blade and the component of the centrifugal force direction acting on the blade is permissible. The results thereof are shown in FIG. 11.

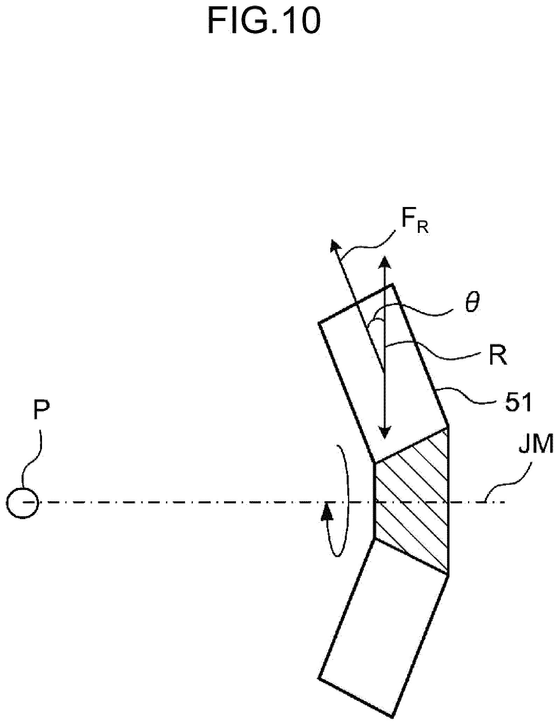

Referring to FIG. 11, θ indicates the degree of deviation between the rolling direction of the blade and the component of the centrifugal force direction acting on the blade, which is defined as an angle between the rolling direction R and the component of the centrifugal force direction F_{R}, as shown in FIG. 10. In this Figure 11, "✔" indicates a case where no blade rupture occurred, while "x" indicates a case where blade rupture occurred.

The operating conditions were as follows: the power input to the electrodes was 9 kW, and the operating time per day was 8 h.

As shown in FIG. 11, in the cases of θ = 82 degrees and θ = 90 degrees, rupture occurred in a part of the blades. More specifically, in the case of θ = 82 degrees, the blade rupture occurred after approximately 64 hours of cumulative operating time, and in the case of θ = 90 degrees, the blade rupture occurred after approximately 44 hours of cumulative operating time.

On the other hand, when θ = 0 degrees, θ = 8 degrees, and θ = 20 degrees, no rupture occurred even when the cumulative operating time reached about 64 hours. At those three levels, the operation continued until the cumulative operating time reached approximately two months, but no defect occurred. Thus, it was confirmed that at least when θ is between 0 degrees and 20 degrees, the above defects are certainly suppressed. As a result, it is preferable to set the angle θ between the rolling direction R and the component of the centrifugal force direction F_{R} to be between 0 degrees and 20 degrees.

As described above, according to the present embodiment, the rotary foil trap 22 is arranged in the vicinity of plasma P generated by the light source unit 2, which is the plasma generation unit, and rotationally operates to transmit light emitted from the plasma P and to trap debris dispersed from the plasma P. The rotary foil trap 22 includes a plurality of foils 51 that are able to rotate about an axis that passes through the plasma P (i.e., rotation axis), and a hub (i.e., support member) 53 that is disposed on the rotation axis and supports the foils (i.e., blades) 51.
Each of the blades 51 is a rolled thin plate that has been tensile processed by rolling and is configured such that the component of the centrifugal force direction F_{R} applied to the blade 51 by the rotational motion coincides or approximately coincides with the rolling direction R of the blade 51. Here, it is preferable for the blade 51 that the angle between the component of the centrifugal force direction F_{R} and the rolling direction R is between 0 degrees and 20 degrees.

As such, it makes it possible to appropriately suppress the occurrence of defects such as the rupture of the blade 51 due to the rotational motion of the rotary foil 22 under an environment subjected to various loads such as thermal radiation from the plasma P, collision with debris, and exposure to light.

In order to avoid defects such as the rupture of the blade 51, it may be alternatively conceivable to thicken the thickness of the blade 51 to increase the strength of the blade 51. However, in terms of the rotary foil trap 22, EUV light is shielded by the thicknesses of respective blades 51. For this reason, in order to maintain the ratio of EUV light passing through the rotary foil trap 22 (i.e., transmittance) at a high transmittance, such as 90 %, it is impossible to thicker the thickness of each of the blades 51.

According to the rotary foil trap 22 of the present embodiment, it makes it possible to attain a rotary foil trap capable of suppressing the occurrence of defects such as rupture of foils (i.e., blades) and having a relatively long operating life, while maintaining the higher transmittance of EUV light by setting the thickness of the blade 51 to be, for example, 0.15 mm.

### (Modification to Embodiments)

Although in the above embodiments, a certain case has been described in which a laser is used as an energy beam to irradiate the high-temperature plasma raw material, alternatively, an ion beam, electron beam, and the like may be used instead of a laser.

Furthermore, although in the above embodiments, a certain case has been described in which the present embodiment is applied to an EUV light source apparatus of the DPP type method, alternatively, the present embodiment may be applied to an EUV light source apparatus of the LPP type method. It should be noted that the LPP type method is a method to irradiate a target material with a driver laser for generating plasma and excite the target material to generate plasma.

Yet furthermore, although in the above embodiment, a certain case has been described in which the light source apparatus equipped with the rotary foil trap 22 is an EUV light source apparatus, alternatively, the light source apparatus may be a VUV light source apparatus that extracts VUV light (vacuum ultraviolet light) or an X-ray generation apparatus that extracts X-rays.

When the light source apparatus functions as a VUV light source apparatus, the VUV light source apparatus may also be used as a light source for surface modification of substrates, ozone generation, and substrate lamination.

On the other hand, when the light source apparatus functions as an X-ray generation apparatus, the X-ray generation apparatus may be used for chest radiography, dental radiography, and the Computer Tomogram (CT) in the medical field. In the industrial field, the X-ray generation apparatus may also be used for non-destructive inspection and tomographic non-destructive inspection to observe the inside of materials such as structures and welds. Furthermore, in the research field, the X-ray generation apparatus may be used for X-ray analysis to analyze the crystal structure of materials and X-ray spectroscopy (e.g., X-ray fluorescence analysis) to analyze the constituent elements of materials.

Although specific embodiments have been described above, the embodiments described are illustrative only and are not intended to limit the scope of the present invention. The apparatus and method described herein may be embodied in other forms than as described above. In addition, it is also possible to appropriately omit, substitute, or modify the above described embodiments without departing from the scope of the present invention. Embodiments with such omissions, substitutions and modifications fall within the scope of the appended claims and equivalents thereof and also fall within the technical scope of the present invention.

### REFERENCE SIGNS LIST

1: Extreme Ultraviolet Light Source Apparatus (EUV Light Source Apparatus); 2: Light Source Unit; 3: Debris Reduction Unit; 4: Debris Container Unit; 11: Chamber; 21: Connecting Chamber; 22: Rotary Foil Trap; 23: Heat Shielding Plate; 24: Static Foil Trap; 31: Debris Containment Vessel; 51: Foils; 52: Outer Ring; 53: Hub; DB: Debris; F: Centrifugal Force Direction; R: Rolling Direction

## Claims

1. A rotary foil trap arranged in a vicinity of plasma generated by a plasma generation unit and configured to rotationally operate to transmit light emitted from the plasma and to trap debris dispersed from the plasma, the rotary foil trap comprising:
a plurality of foils; and
a support member configured to support the plurality of foils,
the plurality of foils each being made of a rolled thin plate that is tensile processed by rolling, and
a direction of centrifugal force applied to the foils by rotational operation coinciding or approximately coinciding with a rolling direction, which is a direction in which the foils are tensile processed.

2. The rotary foil trap according to Claim 1, wherein
an angle between the direction of the centrifugal force and the rolling direction ranges between 0 degrees and 20 degrees.

3. The rotary foil trap according to Claim 1 or 2, wherein
the plasma generation unit is configured to excite a raw material emitting the light to generate the plasma, and
the foils rotationally operate at a temperature at or above a melting point of the raw material.

4. The rotary foil trap according to Claim 1 or 2, wherein
the rolling direction is a direction in which crystal grains constituting the rolled thin plate are elongated.

5. A light source apparatus comprising:
the rotary foil trap according to Claim 1 or 2; and
the plasma generation unit.

6. The light source apparatus according to Claim 5, wherein
the light includes extreme ultraviolet light.
